# EUROPEAN PATENT APPLICATION

(11) **EP 4 324 866 A1**
(43) Date of publication of application: **21.02.2024**
(21) Application number: 22190731.4
(22) Date of filing: 17.08.2022
(51) Int. Cl.: C08G 61/12, C08L 65/00, C09D 165/00, H10K 99/00

(54) **HIGH PURITY SULFONATED THIOPHENE MONOMERS**

(71) Applicant: Heraeus Epurio GmbH, 63450 Hanau (DE)
(72) Inventor: HILL, Stephen, 51368 Leverkusen (DE); LÖVENICH, Wilfried, 51368 Leverkusen (DE); SCHEEL, Arnulf, 51368 Leverkusen (DE)
(74) Representative: Heraeus IP

(57) **Abstract**

The present invention relates to a monomer composition comprising at least one functionalized thiophene monomer having the structure **I** 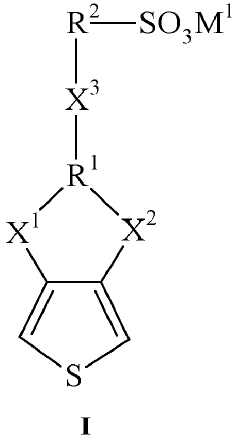 wherein
**X¹** and **X²**
represent independently from each other O or S;
**X³**
represents -CH₂-O- with the carbon atom bonded to **R¹** or represents -O-;
**R¹**
represents a trivalent organic group;
**R²**
represents a divalent organic group;
**M¹**
represents a monovalent cation;

wherein the monomer composition is essentially free of unsaturated organic sulfonic acids having the structure **II** 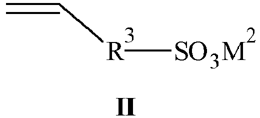 wherein
**R³**
represents a divalent organic group;
**M²**
represents a monovalent cation;

or wherein the monomer composition comprises unsaturated organic sulfonic acids having the structure **II** in such a maximum amount that the molar ratio of the total amount of unsaturated organic sulfonic acids having the structure **II** to the total amount of functionalized thiophene monomers having structure **I** is 1 : 32 or less. The present invention also relates to a process for the preparation of a functionalized π-conjugated polythiophene, to a functionalized π-conjugated polythiophene obtainable by that process, to a polymer composition comprising a functionalized π-conjugated polythiophene, to a process for the preparation of a layered body, to a layered body obtainable by that process and to the use of the monomer composition or of the polymer composition according to the present invention for the preparation of a conductive layer in an electronic device.

## Description

The present invention relates to a monomer composition comprising a functionalized thiophene monomer, to a process for the preparation of a functionalized π-conjugated polythiophene, to a functionalized π-conjugated polythiophene obtainable by that process, to a polymer composition comprising a functionalized π-conjugated polythiophene, to a process for the preparation of a layered body, to a layered body obtainable by that process and to the use of the monomer composition or of the polymer composition according to the present invention for the preparation of a conductive layer in an electronic device.

A commercially available electrolyte capacitor as a rule is made of a porous metal electrode, an oxide layer serving as a dielectric on the metal surface, an electrically conductive material, usually a solid, which is introduced into the porous structure, an outer electrode (contacting), such as e.g., a silver layer, and further electrical contacts and an encapsulation. An electrolyte capacitor which is frequently used is the tantalum electrolytic capacitor, the anode electrode of which is made of the valve metal tantalum, on which a uniform, dielectric layer of tantalum pentoxide has been generated by anodic oxidation (also called *"formation"*)*.* A liquid or solid electrolyte forms the cathode of the capacitor. Aluminium capacitors in which the anode electrode is made of the valve metal aluminium, on which a uniform, electrically insulating aluminium oxide layer is generated as the dielectric by anodic oxidation, are furthermore frequently employed. Here also, a liquid electrolyte or a solid electrolyte forms the cathode of the capacitor. The aluminium capacitors are usually constructed as wound- or stacked-type capacitors.

π-conjugated polymers are particularly suitable as solid electrolytes in the capacitors described above because of their high electrical conductivity. π-conjugated polymers are also called conductive polymers or synthetic metals. They are increasingly gaining economic importance, since polymers have advantages over metals with respect to processability, weight and targeted adjustment of properties by chemical modification. Examples of known π-conjugated polymers are polypyrroles, polythiophenes, polyanilines, polyacetylenes, polyphenylenes and poly(p-phenylene-vinylenes), a particularly important polythiophene used industrially being poly(3,4-ethylenedioxythiophene) (PEDOT) since it has a very high conductivity in its oxidized form.

The solid electrolytes based on conductive polymers can be applied to the oxide layer in various ways. EP-A-0 340 512 describes, for example, the production of a solid electrolyte from 3,4-ethylenedioxythiophene and the use thereof in electrolytic capacitors. According to the teaching of this publication, 3,4-ethylenedioxythiophene is polymerized on to the oxide layer *in situ.* In addition to the *in situ* polymerization a process for the production of solid electrolytes in capacitors in which a dispersion comprising the already polymerized thiophene and a polyanion as a counter-ion, for example the PEDOT/PSS-dispersions (PEDOT = poly(3,4-ethylenedioxythiophene; PSS = polystyrene sulfonic acid) known from the prior art, is applied to the oxide layer and the dispersing agent is then removed by evaporation are also known from the prior art. Such a process for the production of solid electrolyte capacitors is disclosed, for example, in DE-A-10 2005 043 828.

However, PEDOT/PSS-dispersion are characterized by the disadvantage that they comprise a significant amount of PSS as a non-conducting inert material. Furthermore, due to the presence of PSS the size of the PEDOT/PSS-particles in the dispersions is sometimes too large to ensure that the particles also penetrate the smaller pores of the porous metal electrode. Finally, the maximum solids content of PEDOT/PSS-dispersions is often limited to values of about 3 wt.-%. In order to overcome these disadvantages, liquid compositions comprising derivatives of PEDOT have been prepared which are not characterized by the disadvantages of the known PEDOT/PSS-dispersions. Polythiophenes functionalized with sulfonate groups were developed initially. Due to the sulfonate groups, these polythiophenes are self-doped and do not require counter-ions such as PSS.

EP 1 122 274 A1 and US 9,781,905 B2, for example, disclose the preparation of functionalized π-conjugated polymers such as poly(4-(2,3-dihydrothieno[3,4-b][1,4]dioxin-2-ylmethoxy)-1-butanesulfonic acid) or poly(4-(2,3-dihydrothieno[3,4-b][1,4]dioxin-2-ylmethoxy)-2-butanesul-fonic acid) (in the scientific literature both polymers are referred to as "*PEDOT-S*" or *"S-PEDOT*") by oxidative polymerization of the corresponding monomer 4-(2,3-dihydrothieno[3,4-b][1,4]dioxin-2-ylmethoxy)-1-butanesulfonic acid and 4-(2,3-dihydrothieno[3,4-b][1,4]dioxin-2-ylmethoxy)-2-butanesulfonic acid (EDOT-S), respectively (in the scientific literature both monomers are referred to as "*EDOT-S*" or *"S-EDOT"*)*.* These monomers are usually prepared by sulfonation of thieno[3,4-b]-1,4-dioxin-2-methanol ("EDOT-MeOH") or mixtures of EDOT-MeOH and 3,4-(2-hydroxypropylendioxy)-thiophene ("ProDOT-MeOH") with 1,4-butanesultone (for the 1-butansulfonic acid derivative) or 2,4-butanesultone (for the 2-butansulfonic acid derivative), respectively.

However, the electrical conductivity of conductive layers prepared by the polymer solutions obtained by these approaches are still in need of improvement, particularly if these polymer solutions are used for the preparation of, for example, a solid electrolyte layer in a solid electrolyte capacitor.

It was therefore an object of the present invention to overcome the disadvantages of the prior art in the field of π-conjugated polymers.

In particular, it was an object of the present invention to provide polymer compositions comprising a π-conjugated conductive polymer, preferably compositions comprising water-soluble or water-dispersible π-conjugated conductive polymers, even more preferably PEDOT-S-compositions, that, compared to the corresponding compositions known from the prior art, are characterized in that conductive layers prepared by means of these polymer compositions display an increased electrical conductivity.

A contribution to the solution of at least one of the above objects is provided by the subject matter of the category-forming independent claims, wherein the therefrom dependent sub-claims represent preferred embodiments of the present invention, whose subject matter likewise make a contribution to solving at least one object.

|**1a**| A contribution to solving at least one of the objects according to the invention is made by a 1^{st} embodiment of a composition comprising at least one functionalized thiophene monomer having the structure **I** 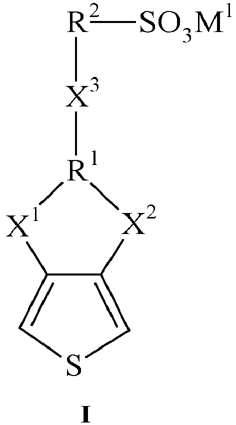 wherein
- **X¹** and **X²**: represent independently from each other O or S, preferably O;
- **X³**: represents CH₂-O with the carbon atom bonded to **R¹** or represents O;
- **R¹**: represents a trivalent organic group, preferably a saturated, linear or branched trivalent hydrocarbon group;
- **R²**: represents a divalent organic group, preferably a saturated, linear or branched alkylene group;
- **M¹**: represents a monovalent cation, preferably a monovalent cation selected from the group consisting of H⁺, NH₄⁺, a tetraalkylamine or an alkali cation, more preferably a monovalent cation selected from the group consisting of H⁺ and Na⁺, most preferably Na⁺;
wherein the monomer composition is essentially free of unsaturated organic sulfonic acids having the structure **II** 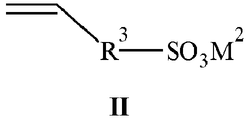 wherein
- **R³**: represents a divalent organic group, preferably a saturated, linear or branched alkylene group;
- **M²**: represents a monovalent cation, preferably a monovalent cation selected from the group consisting of H⁺, NH₄⁺, a tetraalkylamine or an alkali cation, more preferably a monovalent cation selected from the group consisting of H⁺ and Na⁺, most preferably Na⁺, wherein it is furthermore preferred that in a given composition **M¹** and **M²** are at least to a certain extent identical;
or wherein the monomer composition comprises unsaturated organic sulfonic acids having the structure **II** in such a maximum amount that the molar ratio of the total amount of unsaturated organic sulfonic acids having the structure **II** to the total amount of functionalized thiophene monomers having structure **I** is 1 : 32 or less, preferably 1 : 52 or less, more preferably 1 : 82 or less, even more preferably 1 : 112 or less, even more preferably 1 : 132 or less and most preferably 1 : 152 or less.

The term *"essentially free"* as used herein in connection with the amount of unsaturated organic sulfonic acids having the structure **II** preferably indicates that such unsaturated organic sulfonic acids are contained in the monomer composition according to the present invention in an amount below the detection limit when analyzing the composition by ¹H NMR according to the method disclosed herein. In a particularly preferred embodiment of the composition according to the present invention the monomer composition is free of unsaturated organic sulfonic acids having the structure **II.**

It has been observed that EDOT-S monomers known from the prior art that have been prepared by reacting EDOT-MeOH or mixtures of EDOT-MeOH and ProDOT-MeOH with sultones such as 1,4-butanesultone comprise a certain amount of unsaturated organic sulfonic acids having the structure **II.** Surprisingly, it also has been observed that conductive layers that have been prepared using functionalized π-conjugated polythiophenes which in turn have been obtained by polymerizing thiophene monomers comprising a certain amount of such unsaturated organic sulfonic acids show a significantly lower conductivity compared to conductive layers that have been prepared using functionalized π-conjugated polythiophenes which have been obtained by polymerizing thiophene monomers in which the content of such unsaturated organic sulfonic acids is below a certain maximum amount. Unsaturated organic sulfonic acids thus seem to interfere with polymerization.

|**2a**| In a preferred embodiment of the monomer composition according to the present invention, the monomer composition comprises a functionalized thiophene monomer having the structure **Ia** or structure **Ib** or comprises a mixture of functionalized thiophene monomers having structure **Ia** or **Ib** 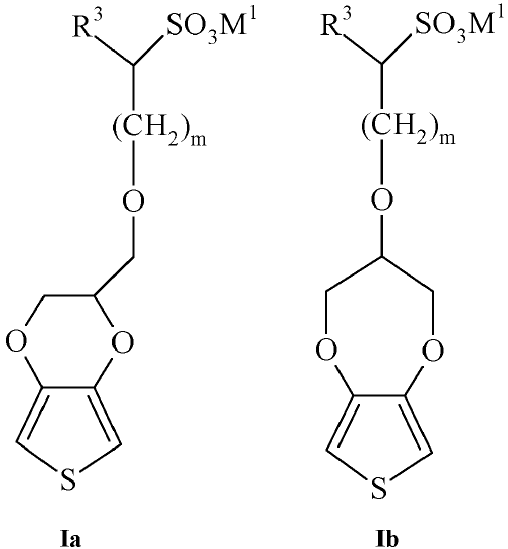 wherein in formulas **Ia** and **Ib**
- **m** is 2, **R³** is -CH₃ and **M¹** is preferably Na⁺;
   or
- **m** is 3, **R³** is H and **M¹** is preferably Na⁺.

The functionalized thiophene monomer is thus preferably sodium 4-[(2,3-dihydrothieno[3,4-b][1,4]dioxin-2-yl)methoxy]butane-1-sulfonate or sodium 4-[(2,3-dihydrothieno[3,4-b][1,4]dioxin-2-yl)methoxy]butane-2-sulfonate. In this context it is also preferred that the unsaturated organic sulfonic acid having the structure **II** is sodium 3-butene-1-sulfonate (in case of sodium 4-[(2,3-dihydrothieno[3,4-b][1,4]dioxin-2-yl)methoxy]butane-1-sulfonate) or 3-butene-2-sulfonate (in case of sodium 4-[(2,3-dihydrothieno[3,4-b][1,4]dioxin-2-yl)methoxy]butane-2-sulfonate). This preferred embodiment is a 2^{nd} embodiment of the monomer composition according to the present invention, that preferably depends on the 1^{st} embodiment.

|**3a**| In a further preferred embodiment of the monomer composition according to the present invention, in formulas **Ia** and **Ib** m is 3, **R³** is H and **M¹** is preferably Na⁺. Thus, according to this preferred embodiment the at least one functionalized thiophene monomer is sodium 4-(2,3-dihydrothieno[3,4-b][1,4]dioxin-2-ylmethoxy)-1-butanesulfonate, wherein the monomer composition may also comprise a mixture of EDOT-S and ProDOT-S as functionalized thiophene monomers. In this context it is also preferred that the unsaturated organic sulfonic acid having the structure **II** is sodium 3-butene-1-sulfonate (i. e., **R³** is -CH₂-CH₂-). This preferred embodiment is a 3^{rd} embodiment of the monomer composition according to the present invention, that preferably depends on the 1^{st} or the 2^{nd} embodiment.

|**4a**| In a further preferred embodiment of the monomer composition according to the present invention, the at least one functionalized thiophene monomer is a mixture of functionalized thiophene monomers having structure **Ia** or **Ib,** wherein the weight ratio of monomers having structure **Ia** to monomers having structure **Ib** (i. e., the weight ratio of EDOT-S to ProDOT-S) in the monomer composition is at least 4 : 1, preferably at least 6 : 1, more preferably at least 8 : 1, even more preferably at least 10 : 1, even more preferably at least 25 : 1, even more preferably at least 50 : 1 and most more preferably at least 100 : 1. This preferred embodiment is a 4^{th} embodiment of the monomer composition according to the present invention, that preferably depends on the 2^{nd} or the 3^{rd} embodiment.

|**5a**| In a further preferred embodiment of the monomer composition according to the present invention, the monomer composition comprises functionalized thiophene monomers having the structure **I** in a total amount of at least 90 wt.-%, preferably at least 92.5 wt.-%, even more preferably at least 95 wt.-%, even more preferably at least 96 wt.-%, even more preferably at least 97 wt.-%, even more preferably at least 98 wt.-%, even more preferably at least 99 wt.-%, even more preferably at least 99.5 wt.-% and most preferably at least 99.9 wt.-%, in each case based on the total weight of the monomer composition. This preferred embodiment is a 5^{th} embodiment of the monomer composition according to the present invention, that preferably depends on anyone of the 1^{st} to the 4^{th} embodiment.

|**6a**| In a further preferred embodiment of the monomer composition according to the present invention, the monomer composition fulfills at least one of the following properties i) and ii), preferably both of these properties:
i) the monomer composition has a colour value **b*** determined according to ASTM E 308-13 of less than 0.75, preferably less than 0.70 and more preferably less than 0.65, the colour value being determined using an aqueous solution that comprises the at least one functionalized thiophene monomer having the structure **I** in a total amount of 1 wt.-% in a quartz glass cuvette of 0.5 mm in transmission;
ii) the monomer composition has a transmission determined for light with a wavelength of 350 nm of at least 90%, preferably at least 91%, more preferably at least 93%, even more preferably at least 94%, even more preferably at least 95% and more preferably at least 96%.

This preferred embodiment is a 6^{th} embodiment of the monomer composition according to the present invention, that preferably depends on the 5^{th} embodiment.

The monomer composition according to the present invention, preferably the monomer composition according to its 5^{th} or 6^{th} embodiment, can be prepared by means of a process comprising the process steps:
**A)** providing a liquid composition comprising a thiophene alkoxy-precursor monomer having the structure **III** 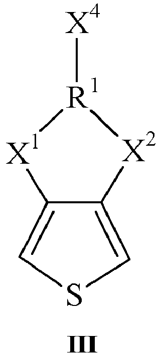 wherein
   - **X¹** and **X²**: represent independently from each other O or S, preferably O;
   - **X⁴**: represents CH₂-O⁻ with the carbon atom bonded to **R¹** or represents O⁻;
   - **R¹**: represents a trivalent organic group, preferably a saturated, linear or branched trivalent hydrocarbon group;
**B)** reacting the thiophene alkoxy-precursor monomer precursor monomer having the structure **III** with a sultone having the structure **IV** 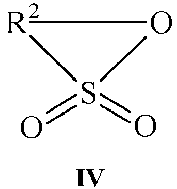 to obtain a reaction mixture that comprises at least one functionalized thiophene monomer having the structure **I,** wherein **R²** represents a divalent organic group, preferably a saturated, linear or branched alkylene group;
**C)** separating the functionalized thiophene monomer having the structure **I** in the form of a solid from the reaction mixture;
**D)** dissolving or dispersing the purified thiophene monomer obtained in process step **C)** in water to obtain aqueous solution or dispersion, preferably an aqueous solution, wherein the aqueous solution or dispersion comprises the functionalized thiophene monomer having the structure **I** preferably in an amount of at least 20 wt.-%, more preferably at least 30 wt.-%, even more preferably at least 40 wt.-% and most preferably at least 50 wt.-%, in each case based on the total weight of the aqueous solution or dispersion;
**E)** providing a C₁-C₅ alcohol, preferably an alcohol selected from the group consisting of methanol, ethanol, 1-propanol, 2-propanol, 1-butanol, 2-butanol, iso-butanol, ter.-butanol, 1-pentanol, 2-pentanol, 3-pentanol, 2-methyl-1-butanol, 2-methyl-2-butanol, 3-methyl-1-butanol, 3-methyl-2-butanol, 2,2-dimethyl-1-propanol or a mixture of at least two of these alcohols, more preferably an alcohol selected from the group consisting of ethanol and 1-bunatol, optionally cooling down the alcohol to a temperature of less than -10°C, preferably less than -15°C and even more preferably less than -20°C and adding the aqueous solution or dispersion comprising the functionalized thiophene monomer having the structure **I** obtained in process step **D)** to the alcohol to obtain an alcoholic solution or dispersion, which - particularly if the alcohol has not been previously cooled - may be cooled down to a temperature of less than -10°C, preferably less than -15°C and even more preferably less than -20°C, thereby obtaining a precipitate comprising a purified thiophene monomer having the structure **I;**
**F)** separating the precipitate from the alcoholic solution or dispersion obtained in process step **G)** to obtain the monomer composition according to the present invention.

In the process disclosed above, the monomer composition obtained in process step **F)** can be further purified by means of a process comprising the process steps
**G)** dissolving or dispersing the purified thiophene monomer obtained in process step **F)** in water to obtain aqueous solution or dispersion, preferably an aqueous solution, comprising the functionalized thiophene monomer having the structure **I,** wherein the aqueous solution or dispersion comprises the functionalized thiophene monomer having the structure **I** preferably in an amount of at least 20 wt.-%, more preferably at least 30 wt.-%, even more preferably at least 40 wt.-% and most preferably at least 50 wt.-%, in each case based on the total weight of the aqueous solution or dispersion;
**H)** cooling down the aqueous solution or dispersion obtained in process step **G)** to a temperature of not more than 15°C, preferably not more than 13°C and most preferably not more than 10°C, thereby again precipitating the functionalized thiophene monomer having the structure **I;**
**I)** separating the precipitate from the aqueous solution or dispersion to obtain the monomer composition according to the present invention.

|**1b**| A contribution to solving at least one of the objects according to the invention is also made by a 1^{st} embodiment of a process 1 for the preparation of a polymer composition comprising a functionalized π-conjugated polythiophene, the process comprising the process steps:
**I)** dissolving or dispersing the monomer composition according to the present invention, preferably the monomer composition according to anyone of its 1^{st} to 6^{th} embodiment, in a solvent or dispersant, preferably in water, to obtain a solution or dispersion of the functionalized thiophene monomer;
**II)** oxidatively polymerizing the functionalized thiophene monomer having the structure **I** in the solution or dispersion provided in process step **I)** to obtain a polymer composition in the form of a solution or dispersion comprising a functionalized π-conjugated polythiophene comprising repeating units having the structure **I'** 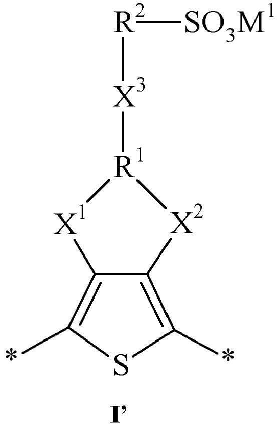 wherein the asterisks (^{∗}) indicate the bond to the adjacent repeating units and wherein **X¹, X², X³, R¹, R²** and **M¹** are as defined for the functionalized thiophene monomer in the monomer composition according to the present invention;
**III)** optionally purification of the solution or dispersion comprising the functionalized π-conjugated polythiophene obtained in process step **II)**, preferably by means of ion filtration.
**IV)** optionally diluting the solution or dispersion comprising the functionalized π-conjugated polythiophene obtained in process step **II)** or in process step **III)**, preferably diluting the solution or dispersion with water.

|**2b**| In a preferred embodiment of process 1 according to the present invention, the solution or dispersion provided in process step **I)** comprises the functionalized thiophene monomer having the structure **I** in an amount in the range from 1 to 50 wt.-%, preferably in the range from 5 to 40 wt.-% and more preferably in the range from 10 to 30 wt.-%, in each case based on the total weight of the solution or dispersion provided in process step **I).** This preferred embodiment is a 2^{nd} embodiment of process 1 according to the present invention, that preferably depends on the 1^{st} embodiment.

|**3b**| In a further preferred embodiment of process 1 according to the present invention, the solution or dispersion provided in process step **I)** further comprises at least one oxidizing agent. This preferred embodiment is a 3^{rd} embodiment of process 1 according to the present invention, that preferably depends on the 1^{st} or the 2^{nd} embodiment.

|**4b**| In a further preferred embodiment of process 1 according to the present invention, the solution or dispersion provided in process step **I)** is an aqueous solution or dispersion and the pH of the aqueous solution or dispersion provided in process step **I)** is adjusted to a value of less than 2.5, preferably less than 2.0 and more preferably less than 1.5 using an organic or inorganic acid, preferably an acid selected from the group consisting of formic acid, acetic acid, lactic acid, propionic acid, citric acid, malic acid, fumaric acid, sulfuric acid, sulfonic acid, nitric acid, phosphonic acid, phosphoric acid or a mixture of at least two of these acids, wherein the use of sulfuric acid is particularly preferred. This preferred embodiment is a 4^{th} embodiment of process 1 according to the present invention, that preferably depends on anyone of the 1^{st} to the 3^{rd} embodiment.

|**5b**| In a further preferred embodiment of process 1 according to the present invention, the oxidative polymerization in process step **II)** is performed under an inert gas atmosphere of nitrogen, argon, carbon dioxide or a mixture thereof. This preferred embodiment is a 5^{th} embodiment of process 1 according to the present invention, that preferably depends on the 1^{st} to the 4^{th} embodiment.

|**6b**| In a further preferred embodiment of process 1 according to the present invention, the oxidative polymerization in process step **II)** is performed under a pressure that is equal to or above the vapor pressure of the aqueous solution or dispersion during the polymerization reaction in process step **II)**. This preferred embodiment is a 6^{th} embodiment of process 1 according to the present invention, that preferably depends on anyone of the 1^{st} to the 5^{th} embodiment.

|**7b**| In a further preferred embodiment of process 1 according to the present invention, the oxidative polymerization in process step **II)** is performed under a reduced pressure of not more than 0.8 bar. This preferred embodiment is a 7^{th} embodiment of process 1 according to the present invention, that preferably depends on anyone of the 1^{st} to the 6^{th} embodiment.

|**8b**| In a further preferred embodiment of process 1 according to the present invention, the purification in process step **III)** is accomplished by means of filtration and/or by means of a treatment with ion exchanger. This preferred embodiment is an 8^{th} embodiment of process 1 according to the present invention, that preferably depends on anyone of the 1^{st} to the 7^{th} embodiment.

|**9b**| In a further preferred embodiment of process 1 according to the present invention, the dilution in process step **IV)** is done to such an extent that the solids content of the polymer composition is in the range from 0.1 to 25 wt.-%, preferably in the range from 0.25 to 10 wt.-% and more preferably in the range from 0.5 to 5 wt.-%, in each case based on the total weight of the polymer composition. This preferred embodiment is an 9^{th} embodiment of process 1 according to the present invention, that preferably depends on anyone of the 1^{st} to the 8^{th} embodiment.

|**1c**| A contribution to solving at least one of the objects according to the invention is also made by a 1^{st} embodiment of a polymer composition 1 comprising a functionalized π-conjugated polythiophene obtainable by process 1 according to the present invention, preferably by process 1 according to anyone of the 1^{st} to the 9^{th} embodiment. Preferably, the functionalized π-conjugated polythiophene obtainable by process 1 is dissolved or dispersed in water as the solvent or dispersant.

|**1d**| A contribution to solving at least one of the objects according to the invention is also made by a 1^{st} embodiment of polymer composition 2 comprising a functionalized π-conjugated polythiophene comprising repeating units having the structure **I'** 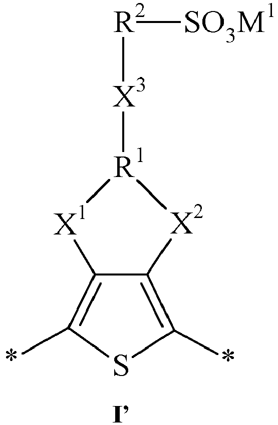 wherein
- **X¹** and **X²**: represent independently from each other O or S, preferably O;
- **X³**: represents CH₂-O with the carbon atom bonded to **R¹** or represents O;
- **R¹**: represents a trivalent organic group, preferably a saturated, linear or branched trivalent hydrocarbon group;
- **R²**: represents a divalent organic group, preferably a saturated, linear or branched alkylene group;
- **M¹**: represents a monovalent cation, preferably a monovalent cation selected from the group consisting of H⁺, NH₄⁺, a tetraalkylamine or an alkali cation, more preferably a monovalent cation selected from the group consisting of H⁺ and Na⁺, most preferably Na⁺;
wherein the asterisks (^{∗}) indicate the bond to the adjacent repeating units; wherein the functionalized π-conjugated polythiophene is essentially free of repeating units having the structure **II'** 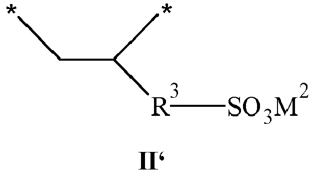 wherein
- **R³**: represents a divalent organic group, preferably a saturated, linear or branched alkylene group;
- **M²**: represents a monovalent cation, preferably a monovalent cation selected from the group consisting of H⁺, NH₄⁺, a tetraalkylamine or an alkali cation, more preferably a monovalent cation selected from the group consisting of H⁺ and Na⁺, most preferably Na⁺, wherein it is furthermore preferred that in a given functionalized π-conjugated polythiophene **M¹** and **M²** are at least to a certain extend identical;
wherein the asterisks (^{∗}) indicate the bond to the adjacent repeating units;
or wherein the functionalized π-conjugated polythiophene comprises repeating units having the structure **II'** in such a maximum amount that the molar ratio of the total amount of repeating units having the structure **II'** to the total amount of repeating units having the structure **I'** is 1 : 32 or less, preferably 1 : 52 or less, more preferably 1 : 82 or less, even more preferably 1 : 112 or less, even more preferably 1 : 132 or less and most preferably 1 : 152 or less.

The term *"essentially free"* as used herein in connection with the amount of repeating units having the structure **II'** preferably indicates that such repeating units are contained in the functionalized π-conjugated polythiophene that is comprised in polymer composition 2 according to the present invention in an amount below the detection limit when analyzing the composition by ¹H NMR according to the method disclosed herein. In a particularly preferred embodiment of the composition according to the present invention the functionalized π-conjugated polythiophene is free of repeating units having the structure **II'.**

Moreover, the term *"polymer composition* 2" as used herein preferably refers to any composition that comprises the functionalized π-conjugated polythiophene comprising repeating units having the structure **I',** irrespective of its aggregate state. Polymer composition 2 can thus, for example, be a dispersion or solution in which the functionalized π-conjugated polythiophene is dissolved or dispersed in a solvent or dispersant, or can be a conductive layer that has been formed by applying such a solution or dispersion onto a substrate and subsequently removing the solvent or dispersant.

|**2d**| In a preferred embodiment of polymer composition 2 according to the present invention, the functionalized π-conjugated polythiophene comprises repeating units having the structure **la'** or structure **Ib'** or comprises a mixture of repeating units having structure **la'** or **Ib'** 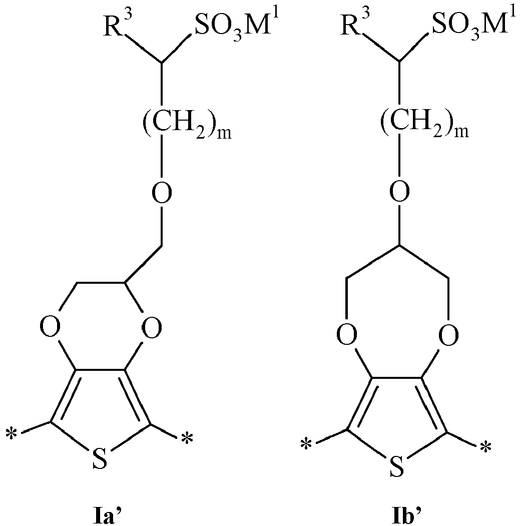 wherein in formulas **la'** and **Ib'**
- **m** is 2, **R³** is -CH₃ and **M¹** is preferably Na⁺;
   or
- **m** is 3, **R³** is H and **M¹** is preferably Na⁺.

The functionalized π-conjugated polythiophene is thus preferably sodium poly(4-[(2,3-dihydrothieno[3,4-b][1,4]dioxin-2-yl)methoxy]butane-1-sulfonate) or sodium poly(4-[(2,3-dihydrothieno[3,4-b][1,4]dioxin-2-yl)methoxy]butane-2-sulfonate). In this context it is also preferred that residue **R³** in the repeating unit having the structure **II'** is a -CH₂-CH₂- group (in case of sodium poly(4-[(2,3-dihydrothieno[3,4-b][1,4]dioxin-2-yl)methoxy]butane-1-sulfonate) or a -CHCH₃- group (in case of sodium poly(4-[(2,3-dihydrothieno[3,4-b][1,4]dioxin-2-yl)methoxy]butane-2-sulfonate). This preferred embodiment is a 2^{nd} embodiment of polymer composition 2 according to the present invention, that preferably depends on the 1^{st} embodiment.

|**3d**| In a further preferred embodiment of polymer composition 2 according to the present invention, in formulas **la'** and **Ib' m** is 3, **R³** is H and **M¹** is preferably Na⁺. Thus, according to this preferred embodiment the functionalized π-conjugated polythiophene is sodium poly(4-(2,3-dihydrothieno[3,4-b][1,4]dioxin-2-ylmethoxy)-1-butanesulfonate), wherein the functionalized π-conjugated polythiophene may also comprise a mixture of EDOT-S and ProDOT-S as repeating units. In this context it is also preferred that residue **R³** in the repeating unit having the structure **II'** is a -CH₂-CH₂- group. This preferred embodiment is a 3^{rd} embodiment of polymer composition 2 according to the present invention, that preferably depends on the 1^{st} or the 2^{nd} embodiment.

|**4d**| In a further preferred embodiment of polymer composition 2 according to the present invention, the functionalized π-conjugated polythiophene comprises a mixture of repeating units having structure **la'** or **Ib',** wherein the weight ratio of repeating units having structure **la'** to repeating units having structure **Ib'** in the functionalized π-conjugated polythiophene is at least 4 : 1, preferably at least 6 : 1, more preferably at least 8 : 1, even more preferably at least 10 : 1, even more preferably at least 25 : 1, even more preferably at least 50 : 1 and most more preferably at least 100 : 1. This preferred embodiment is a 4^{th} embodiment of polymer composition 2 according to the present invention, that preferably depends on the 2^{nd} or the 3^{rd} embodiment.

|**5d**| In a further preferred embodiment of polymer composition 2 according to the present invention, the polymer composition is a liquid polymer composition further comprising at least one solvent or dispersant, wherein the liquid polymer composition preferably comprises the functionalized π-conjugated polythiophene in an amount in the range from 0.1 to 25 wt.-%, more preferably in the range from 0.25 to 10 wt.-% and most preferably in the range from 0.5 to 5 wt.-%, in each case based on the total weight of the liquid polymer composition. The solvent or dispersant is preferably selected from the group consisting of water, aliphatic alcohols, such as methanol, ethanol, isopropanol and butanol, diacetone alcohols, ethylene glycol and glycerol, aliphatic ketones, such as acetone and methyl ethyl ketone, aliphatic nitrites, such as acetonitrile, glycol ethers, such polyethylene glycol methyl ether, and a mixture of at least two of these solvents, in particular a mixture of water and a water-miscible solvent, wherein water is most preferred as the solvent. Such a liquid polymer composition is, for example, obtainable by process 1 according to the present invention and is preferably an aqueous solution or dispersion. This preferred embodiment is a 5^{th} embodiment of polymer composition 2 according to the present invention, that preferably depends on anyone of the 1^{st} to the 4^{th} embodiment.

|**6d**| In a further preferred embodiment of polymer composition 2 according to the present invention the polymer composition comprises further additives, preferably further additives selected from the group consisting of surface-active substances, adhesion promoters, additives which increase the conductivity, organic binders or mixtures of at least two of these further additives. This preferred embodiment is a 6^{th} embodiment of polymer composition 2 according to the present invention, that preferably depends on the any of the 1^{st} to the 5^{th} embodiment, more preferably on the 5^{th} embodiment.

|**7d**| In a further preferred embodiment of polymer composition 2 according to the present invention, the functionalized π-conjugated polythiophene is present in the form of particles, wherein the particle size distribution of these particles is characterized by
i) a dso-value (weight average particle diameter) in the range from 1 to 100 nm, preferably in the range from 1 to 80 nm, more preferably in the range from 1 to 60 nm and most preferable in the range from 5 to 40 nm,
   and
ii) a d₉₀-value of less than 3.5 × dso, preferably less than 3 × dso and more preferably less than 2 × d₅₀.

This preferred embodiment is a 7^{th} embodiment of polymer composition 2 according to the present invention, that preferably depends on the 5^{th} or the 6^{th} embodiment.

|**8d**| In a further preferred embodiment of polymer composition 2 according to the present invention, the functionalized π-conjugated polythiophene is characterized by a ratio of the mass average molecular weight M_{w} to the molar average molecular weight Mₙ (M_{w}/Mₙ) of at least 6, preferably at least 8, more preferably at least 10, more preferably at least 12, more preferably at least 14, more preferably at least 16, more preferably at least 18 and more preferably at least 20. This preferred embodiment is an 8^{th} embodiment of polymer composition 2 according to the present invention, that preferably depends anyone of the 5^{th} to the 7^{th} embodiment.

|**9d**| In a further preferred embodiment of polymer composition 2 according to the present invention, the polymer composition is a conductive layer, wherein the conductive layer comprises the functionalized π-conjugated polythiophene in an amount in the range from 50 to 99.9 wt.-%, preferably in the range from 60 to 99.5 wt.-% and more preferably in the range from 70 to 99 wt.-%, in each case based on the total weight of the conductive layer. Such a polymer composition is, for example, obtainable by process 2 according to the present invention as described below. This preferred embodiment is a 9^{th} embodiment of polymer composition 2 according to the present invention, that preferably depends on anyone of the 1^{st} to the 4^{th} embodiment.

|**10d**| In a further preferred embodiment of polymer composition 2 according to the present invention, a conductive layer made from the polymer composition has a conductivity of at least 250 S/cm, preferably at least 350 S/cm and more preferably at least 450 S/cm. This preferred embodiment is a 10^{th} embodiment of polymer composition 2 according to the present invention, that preferably depends on the 9^{th} embodiment.

|**1e**| A contribution to solving at least one of the objects according to the invention is also made by a 1^{st} embodiment of a process 2 for the preparation of a layered body, comprising the process steps:
**A)** provision of a substrate;
**B)** application of polymer composition 1 or 2 according to the present invention, preferably of a polymer composition 2 according to anyone of its 5^{th} to 8^{th} embodiment, onto at least a part of at least one surface of the substrate;
**C)** optionally at least partial removal of the solvent or dispersant for the formation of a conductive layer that covers at least a part of at least one surface of the substrate.

|**2e**| In a preferred embodiment of process 2 according to the present invention, the substrate is an electrode body of an electrode material, wherein a dielectric covers one surface of this electrode material at least partly under formation of an anode body. This preferred embodiment is a 2^{nd} embodiment of process 2 according to the present invention, that preferably depends on the 1^{st} embodiment.

|**1f**| A contribution to solving at least one of the objects according to the invention is also made by a layered body, obtainable by process 2 according to the present invention, preferably by process 2 according to the 1^{st} or the 2^{nd} embodiment.

|**1g**| A contribution to solving at least one of the objects according to the invention is also made by the use of the monomer composition according to the present invention or of polymer composition 1 or polymer composition 2 according to the present invention, preferably of polymer composition 2 according to anyone of its 5^{th} to 8^{th} embodiment, for the preparation of a conductive layer in an electronic device.

|**2g**| In a preferred embodiment of the use according to the present invention, the electronic device is selected from the group consisting of OLEDs, coated fabrics, photoconductive cells, photoresistors, photoswitches, phototransistors, phototubes, IR detectors, photovoltaic devices, solar cells, coating materials for memory storage devices, field effect resistance devices, antistatic films, biosensors, electrochromic devices, solid electrolyte capacitors, energy storage devices, touch panels and electromagnetic shielding. This preferred embodiment is a 2^{nd} embodiment of the use according to the present invention, that preferably depends on the 1^{st} embodiment.

|**3g**| In a further preferred embodiment of the use according to the present invention the conductive layer is a solid electrolyte layer in a polymer electrolyte capacitor or hybrid electrolyte capacitor. This preferred embodiment is a 3^{rd} embodiment of the use according to the present invention, that preferably depends on the 1^{st} or the 2^{nd} embodiment.

### Process 1 according to the invention

A contribution to solving at least one of the objects according to the invention is made by process 1 for the preparation of a polymer composition comprising a functionalized π-conjugated polythiophene, the process comprising the process steps:
**I)** dissolving or dispersing the monomer composition according to the present invention, preferably the monomer composition according to anyone of its 1^{st} to 6^{th} embodiment, in a solvent or dispersant, preferably in water, to obtain a solution or dispersion of the functionalized thiophene monomer;
**II)** oxidatively polymerizing the functionalized thiophene monomer having the structure **I** in the solution or dispersion provided in process step **I)** to obtain a polymer composition in the form of a solution or dispersion comprising a functionalized π-conjugated polythiophene comprising repeating units having the structure **I'** 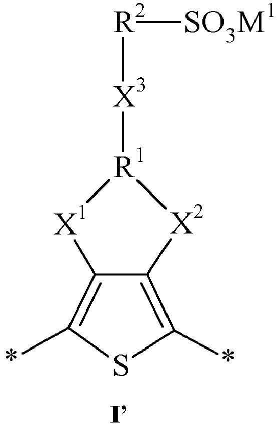 wherein the asterisks (^{∗}) indicate the bond to the adjacent repeating units (and wherein **X¹, X², X³, R¹, R²** and **M¹** are as defined for the functionalized thiophene monomer in the monomer composition according to the present invention;
**III)** optionally purification of the solution or dispersion comprising the functionalized π-conjugated polythiophene obtained in process step **II)**, preferably by means of ion filtration.
**IV)** optionally diluting the solution or dispersion comprising the functionalized π-conjugated polythiophene obtained in process step **II)** or in process step **III)**, preferably diluting the solution or dispersion with water.

The oxidation reaction that is performed in process step **II)** can be catalyzed by a chemical oxidizing agent, by electrochemical oxidation or by a combination of both methods. In case of an electrochemical oxidation an electrode functions as the oxidizing agent.

Suitable oxidizing agents used as chemical oxidizing agents are salts of heavy metals, preferably iron salts, more preferably FeCl₃ and iron(III) salts of aromatic and aliphatic sulfonic acids, H₂O₂, K₂Cr₂O₇, salts of a salt of a peroxodisulfate, such as K₂S₂O₈, Na₂S₂O₈, KMnO₄, alkali metal perborates, and alkali metal or ammonium persulfates, or mixtures of these oxidants. Particularly preferred are salts of a heavy metal, salts of a peroxodisulfate or a mixture thereof.

Further suitable oxidants are described, for example, in Handbook of Conducting Polymers (Ed. Skotheim, T. A.), Marcel Dekker: New York, 1986, Vol. 1, pages 46-57. Particularly preferred oxidizing agents b) are salts of a peroxodisulfate, in particular K₂S₂O₈, Na₂S₂O₈, iron salts, in particular iron(III) chloride, or mixtures of salts of a peroxodisulfate and at least one further compound that catalyzes the cleavage of the peroxodisulfate, like mixtures of salts of a peroxodisulfate and iron salts. According to a particularly preferred embodiment of the process according to the present invention the oxidizing agent is a mixture of Fe₂(SO₄)₃ and Na₂S₂O₈.

Suitable solvents or dispersants that can be used in process 1 according to the present invention are water, water-miscible solvents, in particular those selected from the group consisting aliphatic alcohols, such as methanol, ethanol, isopropanol and butanol, diacetone alcohols, ethylene glycol and glycerol, aliphatic ketones, such as acetone and methyl ethyl ketone, aliphatic nitrites, such as acetonitrile, glycol ethers, such polyethylene glycol methyl ether, or a mixture of at least two of these solvents, in particular a mixture of water and a water-miscible solvent. The most preferred solvent or dispersant, however, is water. In case of 4-(2,3-dihydrothieno[3,4-b][1,4]dioxin-2-ylmethoxy)-1-butanesulfonic acid or 4-(2,3-dihydrothieno[3,4-b][1,4]dioxin-2-ylmethoxy)-2-butanesulfonic acid as the thiophene monomer process 1 according to the present invention therefore enables the production of an aqueous solution or dispersion comprising a functionalized π-conjugated polythiophene.

The concentration of the functionalized thiophene monomer in the solution or dispersion provided in process step I) is preferably in a range from 1 to 50 wt.-%, preferably in the range from 5 to 40 wt.-% and more preferably in the range from 10 to 30 wt.-%,, in each case based on the total weight of the solution or dispersion.

There are different ways of preparing the solution or dispersion provided in process step **I).** The functionalized thiophene monomer can be dissolved or dispersed in the solvent or dispersant, followed by the addition of the oxidizing agent(s) (which can also be dissolved or dispersed in a solvent or dispersant separately), or the oxidizing agent(s) is/are first dissolved or dispersed in the solvent or dispersant, followed by the addition of the functionalized thiophene monomer (which can also be dissolved or dispersed in a solvent or dispersant separately). If more than one oxidizing agent is used, like a mixture of Fe₂(SO₄)₃ and Na₂S₂O₈, it is furthermore possible to first mix one of these components with the functionalized thiophene monomer and the solvent or dispersant and finally add the second oxidizing agent.

The polymerization reaction in process step **II)** is preferably performed at a temperature in the range from -20°C to 200°C, preferably from 0°C to 100°C and for a duration of preferably 1 to 48 hours, more preferably for 5 to 20 hours.

After the polymerization reaction is completed, the solution or dispersion comprising the functionalized π-conjugated polymer, preferably the aqueous solution comprising the functionalized π-conjugated polymer, may be further purified, for example by means of filtration, in particular by means of ultrafiltration, and/or by a treatment with ion exchanger in a further process step **III)**, in particular by a treatment with an anion exchanger and a cation exchanger, for the purpose of further purification. It is also possible to add further additives as described below in connection with the process 1 according to the present invention.

Moreover, the solution or dispersion comprising the functionalized π-conjugated polymer, preferably the aqueous solution comprising the functionalized π-conjugated polymer, that is obtained in process step **II)** and/or that is obtained after purification in process step **III)**, may further be diluted, preferably using any of the solvents or dispersants mentioned above in connection with process step **II)**, more preferably using water, in a further process step **IV).** By means of such a dilution step the solids content of the solution or dispersion is preferably adjusted to be in the range from 0.1 to 25 wt.-%, preferably in the range from 0.25 to 10 wt.-% and more preferably in the range from 0.5 to 5 wt.-%, in each case based on the total weight of the solution or dispersion.

Furthermore, as the functionalized π-conjugated polythiophene obtained after polymerization in process step **II)** is usually present in the form of particles, the particle size distribution of the functionalized π-conjugated polythiophene in the solution or dispersion obtained in process step **II)** or that - after further purification and or after dilution - is obtained in process step **III)** or process step **IV),** can be adjusted by a treatment of the solution or dispersion with ultrasound, wherein the energy input is preferably between 10 - 1000 Watts/liter (W/l), more preferably between 20-500 W/l and the ultrasound frequency is preferably between 20 - 200 kHz, by a treatment of the solution or dispersion with high pressure homogenization, wherein pressures higher than 100 bar, preferably higher than 500 bar and most preferably higher than 1500 bar are applied preferably multiple times, or by a treatment of the solution or dispersion with heat, wherein the heat treatment preferably comprises a treatment of the solution or dispersion at a temperature in the range from 40 to 100°C, preferably at a range from 50 to 95°C for a duration of 5 minutes to 100 hours, preferably 1 to 10 hours and more preferably 2 to 8 hours.

According to a particularly preferred embodiment of process 1 according to the present invention it is also advantageous that the oxygen content of the solution or dispersion provided in process step **I)** is less than 1,000 ppm, preferably less than 500 ppm, more preferably less than 100 ppm, more preferably less than 10 ppm, more preferably less than 1 ppm, more preferably less than 0.5 ppm and most preferably less than 0.25 ppm, in each case based on the total weight of the solution or dispersion. According to a particularly preferred embodiment of process 1 according to the present invention the solution or dispersion provided in process step **I)** is completely free of any oxygen (i. e. the oxygen content is 0 ppm).

There are different approaches of adjusting the oxygen content in the solution or dispersion that is provided in process step **I)** and also to maintain this low oxygen content during the polymerization reaction in process step **II).**

According to one approach the solution or dispersion provided in process step **I)** (or the liquid components that are used to prepare the solution or dispersion) can be degassed, for example by introducing an inert gas such as N₂, Argon, CO₂ or a mixture thereof into the solution or dispersion provided in process step **I)** to reduce the initial oxygen content in the solution or dispersion. Alternatively, the solution or dispersion provided in process step **I)** (or the liquid components that are used to prepare the solution or dispersion) can be subjected to a treatment with a reduced pressure in order to reduce the initial oxygen content, for example by stirring the solution or dispersion while applying a vacuum, or can be subjected to a treatment with ultra sound or can be subjected to a combination of a treatment with a reduced pressure and a treatment with ultra sound.

In order to ensure that the low oxygen content is maintained during the polymerization reaction in process step **II)** it may be advantageous to perform the polymerization reaction under an inert gas atmosphere, preferably under a N₂-atmosphere, under a CO₂-atmosphere, under an argon atmosphere or under an atmosphere of a mixture of at least two of these inert gases, wherein it may also be advantageous that the oxidative polymerization in process step **II)** is performed under a pressure that is equal to or above the vapor pressure of the solution or dispersion during the polymerization reaction in process step **II)**. Preferably, the oxidative polymerization in process step **II)** is performed under a pressure that is at least 0.1 mbar, more preferably at least 0.5 mbar and most preferably at least 1 mbar above the vapor pressure of the solution or dispersion during the polymerization reaction in process step **II)**. To ensure that the low oxygen content is maintained during the polymerization reaction in process step **II)** it is also possible to perform the oxidative polymerization in process step **II)** under a reduced pressure, preferably under a pressure of not more than 0.8 bar and most preferably under a pressure of not more than 0.5 bar.

### Process 2 according to the invention

A contribution towards achieving the abovementioned objects is also made by process 2 for the preparation of a layered body, comprising the process steps:
**A)** provision of a substrate;
**B)** application of the liquid polymer composition 1 or a liquid polymer composition 2 according to the present invention, preferably liquid polymer composition 2 according to anyone of its 5^{th} to 8^{th} embodiment, onto at least a part of at least one surface of the substrate;
**C)** optionally at least partial removal of the solvent for the formation of a conductive layer that covers at least a part of at least one surface of the substrate.

According to a particularly preferred embodiment of process 2 according to the present invention the substrate is an electrode body of an electrode material, wherein a dielectric covers one surface of this electrode material at least partly under formation of an anode body. In such an embodiment process steps **A)** and **B)** thus comprise the process steps:
**A)** the provision of an electrode body of an electrode material, wherein a dielectric covers one surface of this electrode material at least partly under formation of an anode body;
**B)** the introduction of polymer composition 1 or 2 according to the present invention, preferably of liquid polymer composition 2 according to anyone of its 5^{th} to 8^{th} embodiment, into at least a part of the electrode body;

In process step **A),** an electrode body of an electrode material, wherein a dielectric covers one surface of this electrode material at least partly to form an anode body, is first provided.

In principle, the electrode body can be produced by pressing a valve metal powder of high surface area and sintering it to give a usually porous electrode body. An electrical contact wire, preferably of a valve metal, such as e.g., tantalum, is conventionally also pressed into the electrode body here. The electrode body is then coated, for example by electrochemical oxidation, with a dielectric, i.e., an oxide layer. Alternatively, metal foils can also be etched, and coated with a dielectric by electrochemical oxidation in order to obtain an anode foil having a porous region. In a wound capacitor, an anode foil having a porous region, which forms the electrode body, and a cathode foil are separated by separators and wound up.

In the context of the invention, valve metal is to be understood as meaning those metals of which the oxide layers do not render possible current flow equally in both directions. In the case of an anodically applied voltage, the oxide layers of the valve metals block the current flow, while in the case of a cathodically applied voltage large currents occur, which may destroy the oxide layer. The valve metals include Be, Mg, Al, Ge, Si, Sn, Sb, Bi, Ti, Zr, Hf, V, Nb, Ta and W and an alloy or compound of at least one of these metals with other elements. The best-known representatives of the valve metals are Al, Ta and Nb. Compounds which have electrical properties comparable to a valve metal are those having metallic conductivity, which can be oxidized and of which the oxide layers have the properties described above. For example, NbO has metallic conductivity, but in general is not regarded as a valve metal. Layers of oxidized NbO have, however, the typical properties of valve metal oxide layers, so that NbO or an alloy or compound of NbO with other elements are typical examples of such compounds which have electrical properties comparable to a valve metal. Electrode materials of tantalum, aluminium and those electrode materials based on niobium or niobium oxide are preferred. Tantalum and aluminium are very particularly preferred as the electrode material.

For production of the electrode body, often with a porous region, the valve metals can be sintered, for example in powder form, to give a usually porous electrode body, or a porous structure is stamped on a metallic body. The latter can be carried out e.g., by etching a foil.

For simplicity, bodies having a porous region are also called porous in the following. Thus, for example, electrode bodies having a porous region are also called porous electrode bodies. On the one hand, the porous bodies can be permeated by a plurality of channels and therefore be sponge-like. This is often the case if tantalum is used for construction of the capacitor. Furthermore, it is possible for only the surface to have pores and for the region following under the surface pores to be solid in construction. Such a situation is often observed if aluminium is used for construction of the capacitor. Preferably, the electrode body is porous.

The often-porous electrode bodies produced in this manner are then oxidized, for example, in a suitable electrolyte, such as e.g., phosphoric acid or an aqueous solution of ammonium adipate, by application of a voltage, in order to form the dielectric. The level of this formation voltage depends on the oxide layer thickness to be achieved or the later use voltage of the capacitor. Preferred formation voltages lie in a range of from 1 to 1000 V, particularly preferably in a range of from 2 to 500 V, very particularly preferably in a range of from 1 to 300 V. According to a first particular embodiment of the process for the production of a capacitor the formation voltage is in a range of from 1 to 20 V, whereas according to a second particular embodiment of the process for the production of a capacitor the formation voltage is in a range of from 30 to 100 V.

The as a rule porous electrode bodies employed preferably have a porosity of from 10 to 90%, preferably from 30 to 80%, particularly preferably from 50 to 80% and an average pore diameter of from 10 to 10,000 nm, preferably from 20 to 5,000 nm, particularly preferably from 50 to 3,000 nm.

According to a particular embodiment of process 2 according to the invention, the electrolyte capacitor to be produced is an aluminium wound capacitor. In this case, a porous aluminium foil is formed anodically as the electrode material, an aluminium oxide coating being formed as the dielectric. The aluminium foil (anode foil) obtained in this manner is then provided with a contact wire and wound up with a further optionally porous aluminium foil (cathode foil) likewise provided with a contact wire, these two foils being spaced from one another by one or more separators, which are based e.g., on cellulose or, preferably, on synthetic papers. After being wound up, the anode bodies obtained in this way are fixed, for example by means of an adhesive tape. The separator or separators can be carbonized by heating in an oven. This method and manner of production of anode bodies for aluminium wound capacitors is adequately known from the prior art and is described, for example, in US 7,497,879 B2.

According to further particular embodiments of process 2 according to the invention, the electrolyte capacitor to be produced is an aluminium stacked capacitor or a tantalum electrolytic capacitor ("tantalum elco"), in particular a tantalum electrolytic capacitor having a polymeric outer layer, such as is described in DE-A-10 2009 007 594.

In process step **B)** of process 2 according to the invention, polymer composition 1 or 2 according to the present invention, preferably polymer composition 2 according to anyone of its 5^{th} to 8^{th} embodiment, is introduced into at least a part of the anode body. In this context it should be noted that, before introducing polymer composition 1 or 2 into at least a part of the anode body, other compositions may be introduced into the anode body for the formation of an electrically conductive layer, such as a PEDOT/PSS-dispersion. It is therefore not necessarily required to directly apply polymer composition 1 or 2 onto at least a part of the dielectric layer of the anode body.

Polymer composition 1 or 2, preferably polymer composition 2 according to anyone of its 5^{th} to 8^{th} embodiment, is introduced into the porous region by known processes, e.g., impregnation, dipping, pouring, dripping on, spraying, misting on, knife coating, brushing or printing, for example ink-jet, screen or tampon printing. Preferably, the introduction is carried out by dipping the anode body into the polymer polymer composition and thus impregnating it with this polymer composition. The dipping into or the impregnation with the polymer composition is preferably carried out for a period in a range of from 1 second to 120 minutes, particularly preferably in a range of from 5 seconds to 60 minutes and most preferably in a range of from 10 seconds to 15 minutes. The introduction of the polymer composition into the anode body can be facilitated, for example, by increased or reduced pressure, vibration, ultrasound or heat.

Polymer composition 2 according to anyone of its 5^{th} to 8^{th} embodiment that is preferably employed in process step **B)** can, besides the functionalized π-conjugated polymer, the solvent or dispersion and optionally a reminder of the oxidizing agent in its reduced form, moreover comprise further additives, such as surface-active substances, e.g. anionic surfactants, such as e.g. alkylbenzenesulphonic acids and salts, paraffin sulphonates, alcohol sulphonates, ether sulphonates, sulphosuccinates, phosphate esters, alkyl ether carboxylic acids or carboxylates, cationic surfactants, such as e.g. quaternary alkylammonium salts, nonionic surfactants, such as e.g. linear alcohol ethoxylates, oxo alcohol ethoxylates, alkylphenol ethoxylates or alkyl polyglucosides, in particular surfactants that are commercially available under the trademarks Dynol^{®} and Zonyl^{®}, or adhesion promoters, such as e.g. organofunctional silanes or hydrolysates thereof, e.g. 3-glycidoxypropyltrialkoxysilane, 3-amino-propyl-triethoxysilane, 3-mercaptopropyltrimethoxysilane, 3-methacryloxypropyltrimethoxy-silane, vinyltrimethoxysilane or octyltriethoxysilane, crosslinking agents, such as melamine compounds, masked isocyanates, functional silanes - e.g. tetraethoxysilane, alkoxysilane hydrolysates, e.g. based on tetraethoxysilane, epoxysilanes, such as 3-glycidoxypropyltrialkoxysilane - polyurethanes, polyacrylates or polyolefin dispersions.

Polymer composition 2 according to anyone of its 5^{th} to 8^{th} embodiment that is preferably employed in process step **B)** comprise further additives which optionally increase the conductivity, such as e.g. compounds containing ether groups, such as e.g. tetrahydrofuran, compounds containing lactone groups, such as γ-butyrolactone, γ-valerolactone, compounds containing amide or lactam groups, such as caprolactam, N-methylcaprolactam, N,N-dimethylacetamide, N-methylacetamide, N,N-dimethylformamide (DMF), N-methylformamide, N-methylformanilide, N-methylpyrrolidone (NMP), N-octylpyrrolidone, pyrrolidone, sulphones and sulphoxides, such as e.g. sulpholane (tetramethylene sulphone), dimethylsulphoxide (DMSO), sugars or sugar derivatives, such as e.g. sucrose, glucose, fructose, lactose, sugar alcohols, such as e.g. sorbitol, mannitol, furan derivatives, such as e.g. 2-furancarboxylic acid, 3-furancarboxylic acid, glycerol, diglycerol, triglycerol or tetraglycerol.

Polymer composition 2 according to anyone of its 5^{th} to 8^{th} embodiment that is preferably employed in process step **B)** can moreover comprise as a further additive one or more organic binders which are soluble in water or water-miscible solvents. Moreover, polymer composition 2 may also comprise as a further additive one or more compounds which increase the heat stability of the electrical conductive layers, such as e.g. aromatic compounds with at least two OH groups, such as e.g. gallic acid (3,4,5-trihydroxybenzoic acid), tannin or flavonoids.

The viscosity of polymer composition 2 according to anyone of its 5^{th} to 8^{th} embodiment that is preferably employed in process step **B)** can be between 0.01 and 1,000 mPa×s (measured with a rheometer at 20 °C and a shear rate of 100 s⁻¹), depending on the method of application. Preferably, the viscosity is 1 to 500 mPa×s, particularly preferably between 1 to 250 mPa×s. In the case of the production of aluminium wound capacitors the viscosity is very particularly preferably in a range of from 1 to 200 mPa×s, while in the production of tantalum electrolytic capacitors or aluminium stacked capacitors it is very particularly preferably in a range of from 1 to 50 mPa×s. The adjustment of the viscosity can, for example, be accomplished by adding appropriate rheology modifiers as a further additive.

The solids content of polymer composition 2 according to anyone of its 5^{th} to 8^{th} embodiment that is preferably employed in process step **B)** is preferably in a range of from 0.01 to 20 wt.-%, particularly preferably in a range of from 0.1 to 15 wt.-% and most preferably in a range of from 0.25 to 10 wt.-%, in each case based on the total weight of the liquid polymer composition. The solids content of the liquid polymer composition is determined via drying of the liquid polymer composition at a temperature which is sufficiently high to remove the solvent or dispersant.

According to a particularly preferred embodiment of process 2 according to the present invention polymer composition 2 according to anyone of its 5^{th} to 8^{th} embodiment that is introduced into the capacitor body not only comprises the functionalized π-conjugated polymer, but - in addition to this self-doped conductive polymer - a foreign doped conductive polymer, preferably PEDOT/PSS, as disclosed in WO 2014/048562 A2. The disclosure of WO 2014/048562 A2 regarding the combined use of self-doped polymers like PEDOT-S and foreign-doped polymers like PEDOT/PSS for the formation of a solid electrolyte is incorporated herein by reference and forms a part of the disclosure of the present application.

After the anode bodies have been impregnated with polymer composition 2 according to anyone of its 5^{th} to 8^{th} embodiment as described above, it is advantageous to at least partially remove the solvent or dispersant contained in the polymer composition in a subsequent process step **C),** so that a solid electrolyte which completely or partly covers the dielectric, and therefore a capacitor body is formed. In this context it is preferable for the covering of the dielectric by the solid electrolyte to be preferably at least 10%, particularly preferably at least 25% and most preferably at least 50%, it being possible for the covering to be determined by measurement of the capacitance of the capacitor in the dry and in the damp state at 120 Hz, as is described in DE-A-10 2005 043 828.

The removal or hardening is preferably carried out by removing the solvent from the polymer composition and drying it, the drying preferably being carried out at a temperature in a range of from 20°C to 260°C, particularly preferably in a range of from 50°C to 220°C and most preferably in a range of from 80°C to 200°C. It is, of course, also possible to at least partially remove the solvent or dispersant by freeze drying. Process steps **B)** and **C)** can also be repeated once or several times, in order in this manner to adapt the thickness of the layer of the solid electrolyte deposited on the dielectric or the degree of filling of the electrolyte in the electrode body to the particular requirements.

After the capacitor bodies have been produced in this manner, they can be further modified by the method and manner known to the person skilled in the art. In the case of a tantalum electrolytic capacitor, the capacitor bodies can be covered, for example, with a polymeric outer layer, as is described in DE-A-10 2004 022674 or DE-A-10 2009 007 594, and/or a graphite layer and a silver layer, as is known from DE-A-10 2005 043 828, while in the case of an aluminium wound capacitor, in accordance with the teaching of US 7,497,879 B2, the capacitor body is incorporated into an aluminium beaker, provided with a sealing glass and firmly closed mechanically by crimping. The capacitor can then be freed from defects in the dielectric in a known manner by ageing.

The invention is now explained in more detail with the aid of non-limiting figures and examples.
Fig. 1 shows the correlation between the conductivity of conductive layers prepared by means of PEDOT-S compositions according to the present invention and the content of sodium 3-butene-1-sulfonate in the EDOT-S-monomer solutions from which the PEDOT-S has been prepared.

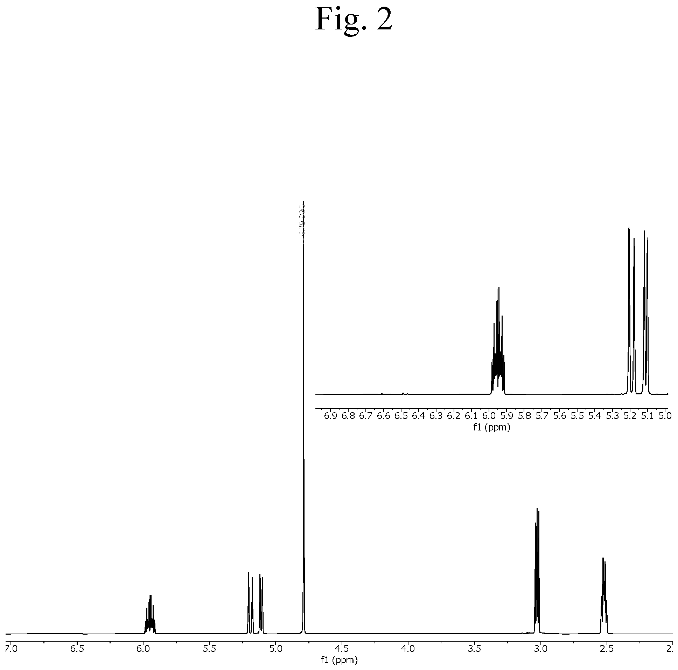

Fig. 2 shows the ¹H NMR spectra (D₂O) of sodium 3-butene-1-sulfonic acid (Butene-S Na).

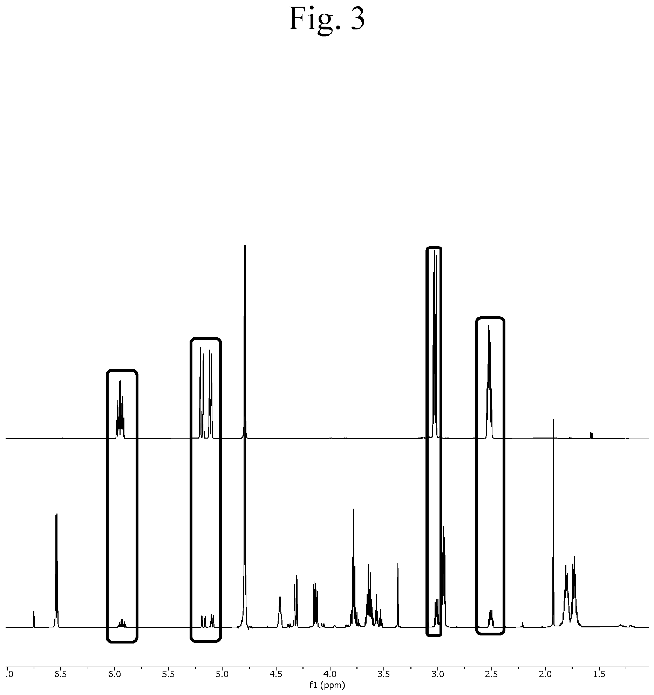

Fig. 3 shows the ¹H NMR spectra comparison (D₂O) of Butene-S Na (above) and a Butene-S Na enriched EDOT-S Na monomer product mixture (below).

### TEST METHODS

### UV/VIS-Spectroscopy (Transmission) and measurement of colour value b*

Colour value b^{∗} was determined according to ASTM E 308-13.

Prior to measurement, a 1 wt.-% solution of the given functionalized thiophene monomer was produced using fully deionized water until a fully solubilized solution was afforded. The transmission spectra were taken with a Perkin Elmer Lambda900 UV/VIS/NIR Spectrometer with a resolution of 5 nm per data point. The lamp was allowed to run for 30 minutes prior to a measurement.

All spectra were produced using quartz glass cuvettes (0.5 mm). A background transmission spectrum (200 - 2500 nm) was taken with fully deionized water to generate a baseline spectrum. Thereafter, the 1% solution is measured. Having generated a transmission spectrum, the colour value **b*** was determined using WinCol software by selecting illuminant D65 and a 10° observer.

### Determination of the content of unsaturated organic sulfonic acids by means of ¹H NMR

The content of unsaturated organic sulfonic acids, particularly the content of sodium 3-butene-1-sulfonate in compositions of functionalized thiophene monomers was determined by means of ¹H NMR via the presence of characteristic peaks. Table 1 shows these characteristic peaks for 3-butene-1-sulfonate (Butene-S Na).

**Table 1: ¹H NMR Signals of the sodium 3-butene-1-sulfonate**

| Proton Identity | ¹H NMR Shift / ppm | Proton Count |
|---|---|---|
| 1 | 5.14 | 2H |
| 2 | 5.95 | 1H |
| 3 | 2.52 | 2H |
| 4 | 3.03 | 2H |

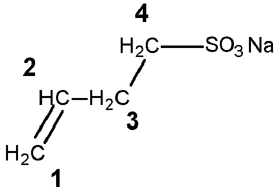

The integration of EDOT-S Na and ProDOT-S Na aromatic thiophene protons (6.53 and 6.74 ppm, respectively) and those of terminal alkene protons (1) allowed determination of the respective three component molar ratio (EDOT-S Na, ProDOT-S Na and Butene-S Na).

### Conductivity

A cleaned glass substrate of size 50 mm × 50 mm was laid on a spin coater and 10 ml of the liquid composition according to the invention was distributed over the substrate. The remaining solution was then spun off by rotation of the plate. Thereafter, the substrate thus coated was dried for 15 minutes at 130°C on a hot plate. The layer thickness was then determined by means of a layer thickness measuring device. (Tencor, Alphastep 500). The conductivity was determined in that Ag electrodes of 25 mm length were vapor deposited at a distance of 10 mm via a shadow mask. The surface resistance determined with an electrometer (Keithly 614) was multiplied by the layer thickness in order to obtain the specific electrical resistivity. The conductivity is the inverse of the specific electrical resistivity.

### Average

If not otherwise mentioned, the average corresponds to the arithmetical average value.

### Solid content

The solid content was determined by gravimetry using a precision scale (Mettler AE 240). First the empty weighing bottle including lid is weighed (Weight A). Then 3 g of dispersion to be analysed is filled into the bottle, closed by the lid and weighed again to determine the exact total weight (weight B). The bottle is placed in a drying oven with ventilation (Memmert UNB200) at 100 °C for 16 hours. When the sample bottle is removed from the oven, immediate coverage by the glass lid is important due to the hygroscopic nature of the dry dispersion material. After 10 - 15 min of cooling down period the bottle is weighed again including lid to determine weight C. There are always at least 2 further repeats conducted to allow determine of an average solid contents.

### EXAMPLES

### Example 1: synthesis of EDOT-MeOH /ProDOT-MeOH (non-inventive)

EDOT-MeOH, the precursor compound to EDOT-S Na, was produced in a multi-step synthesis from dimethyl 3,4-dihydroxythiophene-2,5-dicarboxylate in accordance with Chevrot et al. (J. Electroanal. Chem. 1998, 443, 217-226). The synthesis proceeds in 3 steps as follows:

### Step 1

Dimethyl 3,4-dihydroxythiophene-2,5-dicarboxylate (14.0 g, 54 mmol) was dissolved in ethanol (270 mL) and heated to reflux. Under reflux, epibromohydrine (6 mL, 70 mmol) and a solution of potassium carbonate (1.5 g, 11 mmol) in distilled water (80 mL) were then added to the reaction solution. The mixture was refluxed for 1 h, then additional amounts of epibromohydrine (10.4 g, 122 mmol) and potassium carbonate (0.8 g, 6 mmol) were added. The reaction was refluxed for a further 72 h. The resulting solution was extracted twice with chloroform (200 mL). The organic layer was then washed with an aqueous 5% solution of potassium chloride (200 mL). After drying the organic phase over MgSO₄ and filtration, the solvent was removed under vacuum by rotary evaporation. A yellow solid was obtained which was recrystallized from diethyl ether (100 ml) to give a white crystalline powder (Intermediate 1, 78% yield). Intermediate 1 was obtained with an approximate six (EDOT) : seven (ProDOT) membered ring ratio of 90 : 10, respectively.

Intermediate 1: Thieno[3,4-*b*]-1,4-dioxin-5,7-dicarboxylic acid, 2,3-dihydro-2-(hydroxymethyl)-5,7-dimethyl ester and isomer.

### Step 2

Intermediate **1** from step 1 (11.54 g, 36 mmol) was added to a solution of potassium hydroxide (12 g; 214 mmol) in distilled water (250 mL). The solution was heated to reflux for a total of 2 h after complete solubilization of the reactants. The volume of the solution was then reduced to 100 mL by rotary evaporation. Conc. HCl (24 mL) was added slowly to the cooled solution (ice bath) with continuous stirring. After 2 h the white precipitate was isolated by filtration and dried under vacuum at 80°C to afford solid intermediate 2 (9.22 g, 35 mmol, 97%) as a light gray powder.

Intermediate **2:** 2,3-Dihydro-2-(hydroxymethyl)thieno[3,4-b]-1,4-dioxin-5,7-dicarboxylic acid and isomer.

### Step 3

Intermediate **2** from step 2 (9.22 g, 35 mmol) was mixed with copper chromite catalyst (1 g, 3.2 mmol) and freshly distilled quinoline (50 mL). The suspension was refluxed at 180°C under nitrogen for 2 h. After cooling, diethyl ether was added, and the insoluble precipitate removed by filtration. The subsequent filtrate was washed with 5% HCl and 5% potassium chloride solution. The organic phase was dried over MgSO₄, filtered and the filtrate was concentrated by rotary evaporation. The afforded residue was purified by column chromatography (diethyl ether : cyclohexane (95 : 5)) to obtain 2,3-Dihydrothieno[3,4-*b*][1,4]dioxin-2-yl)methanol (EDOT-MeOH) (3.22 g, 19 mmol, 54%).

The final EDOT-MeOH : ProDOT-MeOH ratio was obtained in an approximate 90 : 10 ratio (as determined by ¹H NMR).

### Example 2: Synthesis of EDOT-S Na /ProDOT-S Na including alkene (non-inventive)

For the preparation of the EDOT-S Na monomer with a sulfonic acid sidechain, the product of Example 1, EDOT-MeOH, was reacted in an additional step in accordance with Chevrot et al. (J. Electroanal. Chem. 1998, 443, 217-226).

Sodium hydride (0.38 g, 16 mmol, 60% oil dispersion) was added to dry toluene (50 mL) and placed under a nitrogen atmosphere and with continuous stirring. EDOT-MeOH (2.24 g, 13 mmol), as prepared in Example 1, dissolved in toluene (20 mL) was slowly added with vigorous stirring. The reaction mixture was heated to reflux for 1 h. Then 1,4-butanesultone (1.8 g, 13 mmol) dissolved in 15 mL toluene was slowly added dropwise to the stirring solution. The reaction was refluxed for a further 2 h and stirred at room temperature for 17 h. Acetone (200 mL) was added under vigorous stirring. The resulting suspension was filtered through a fritted filter and washed with additional acetone under a nitrogen atmosphere. The product was dried at 40°C under vacuum to obtain *"Sample* #*1*" as an orange/off-white powder (3.7 g, 11.2 mmol, 86%).

For Example 2, the resulting product mixture ratio of EDOT-S Na : ProDOT-S Na : Butene-S Na (= sodium 3-butene-1-sulfonate) was about 77.9 : 16.7 : 5.4 (as determined by ¹H NMR).

### Example 3: purification A of EDOT-S Na (inventive)

The product mixture as obtained in Example 2 (30 g) was dissolved in dist. water (30 g) at 80°C up to 1 h or until a 50 mass% solution was obtained. The solution was filtered to remove undissolved solid. The solution was cooled to room temperature. EtOH (100 mL) was externally cooled by dry ice (-40°C) and was stirred whilst the EDOT-S Na solution was added dropwise over 30 min with an additional 1 h of stirring post addition. The subsequent suspension was filtered over a fritted filter and the yellow solid was dried for at least 3 days in a vacuum cupboard (50°C) to obtain *"Sample* #2" (recovered mass = 93%).

EDOT-S Na with reduced alkene content was obtained with an EDOT-S Na : ProDOT-S Na : Butene-S Na molar ratio of about 80 : 17 : 3 (as determined by ¹H NMR).

### Example 4: Purification B of EDOT-S Na (inventive)

The product mixture as obtained in Example 2 (50 g) was dissolved in dist. water (50 g) at 80°C up to 1 h or until a 50 mass% solution was obtained. The solution was filtered to remove undissolved solid. The solution was cooled to room temperature. EtOH (350 mL) was externally cooled by dry ice (-20°C) and was stirred whilst the EDOT-S Na solution was added dropwise over 2-3 h with an additional 1 h of stirring post addition. The subsequent suspension was filtered over a fritted filter and the yellow solid was dried for at least 3 days in a vacuum cupboard (50°C) to obtain *"Sample* #3" (recovered mass = 68%).

EDOT-S Na with reduced alkene content was obtained with an EDOT-S Na : ProDOT-S Na : Butene-S Na molar ratio of about 84 : 15 : 1.2 (as determined by ¹H NMR).

### Example 5: purification C of EDOT-S Na (inventive)

The product mixture as obtained in Example 2 (5 g) was dissolved in dist. water (20 g) at 80°C for 1 h or until a 20 mass% solution was obtained. The solution was filtered to remove undissolved solid. The solution was cooled to room temperature. *n*BuOH (250 mL) was externally cooled by dry ice (-40°C) and was stirred whilst the EDOT-S Na solution was added dropwise over 30 min with an additional 1 h of stirring post addition. The subsequent suspension was filtered over a fritted filter and the yellow solid was dried for at least 3 days in a vacuum cupboard (50°C) to obtain *"Sample #4"* (recovered mass = 42%).

EDOT-S Na with reduced alkene content was obtained with an EDOT-S Na : ProDOT-S Na : Butene-S Na molar ratio of about 99 : 0.5 : 0.75 (as determined by ¹H NMR).

### Example 6: purification D of EDOT-S Na (inventive)

The product mixture as obtained in Example 4 (20 g) was dissolved in dist. water (30 mL) at 80°C for 1 h or until a 40 mass% dark orange solution was obtained, which was allowed to slowly cool to room temperature. Then the solution was cooled to 9°C using a thermostat-controlled cooling system for ca. 48 h and a precipitate was observed. Filtration over a fritted filter and subsequent drying in a vacuum cupboard (50°C) for at least 3 days yielded a light-yellow solid as *"Sample* #*5*" (recovered mass = 58%).

Over purification steps B and D a high purity EDOT-S Na was obtained (overall recovered mass = 39%) with an EDOT-S Na : ProDOT-S Na : Butene-S Na molar ratio of about 98.5 : 1.5 : 0 (as determined by ¹H NMR).

### Example 7: polymerization of product mixture formed in Example 2 (non-inventive)

The product mixture as obtained in Example 2 (5.00 g) was dissolved in dist. water (25 mL) and was degassed using nitrogen for 60 min, whilst cooling to 10°C. Iron(III)sulfate (0.8 g, 2 mmol) was dissolved in dist. water (5 mL) and degassed using nitrogen for 30 min. The iron(III)sulfate solution was then added in one portion to the EDOT-S Na solution. Then DMSO (30 mg, 0.38 mmol) was added to the solution too. Sodium persulfate (3.98 g, 16.7 mmol) was added to dist. water (10 mL) and degassed with nitrogen for 60 min. The reaction solution was stirred throughout, and the temperature was maintained at 10°C for the entirety of the slow addition of the sodium persulfate solution. The reaction ran for 17 h with warming to room temperature, whereafter the solution was added to ion exchangers (Lewatit^{®} S108H and Lewatit^{®} MP 62) and the mixture was stirred at room temperature for 30 min. The process was repeated 3 times with a filtration after every round. After the ion exchangers had been filtered off, the solution was diluted to 0.87% solids content. Subsequent ultrasonic treatment yielded a dark blue polymer solution.

### Example 8: polymerization of product mixture formed in Example 3 (inventive)

The product mixture as obtained in Example 3 (5.00 g) was polymerized according to the protocol outlined in Example 7 to afford a dark blue polymer solution with 1.10% solids content.

### Example 9: polymerization of product mixture formed in Example 4 (inventive)

The product mixture as obtained in Example 4 (5.00 g) was polymerized according to the protocol outlined in Example 7 to afford a dark blue polymer solution with 1.07% solids content.

### Example 10: polymerization of product mixture formed in Example 5 (inventive)

The product mixture as obtained in Example 5 (5.00 g) was polymerized according to the protocol outlined in Example 7 to afford a dark blue polymer solution with 1.16% solids content.

### Example 11: polymerization of product mixture formed in Example 6 (inventive)

The product mixture as obtained in Example 6 (5.00 g) was polymerized according to the protocol outlined in Example 7 to afford a dark blue polymer solution with 1.2% solids content.

Table 2 shows the purity ratios (EDOT-S Na : ProDOT-S Na: Butene-S Na) and the colour value **b*** for product mixtures prepared according to Examples 2-6. Table 3 shows the resulting polymer thin film conductivities and % solids contents for each respective polymer dispersion as produced according to Examples 7-11.

**Table 2: EDOT-S Na : ProDOT-S Na : Butene-S Na Ratio and colour value b* of thiophen monomers produced in Examples 2-6**

| | | | | % molar content | | | molar ratio Butene-S : (EDOT-S + ProDOT-S) |
|---|---|---|---|---|---|---|---|
| Sample # of EDOT-S | Example | colour value **b*** | % transmission (350 nm) | EDOT-S Na | ProDOT-S Na | Butene-S Na | |
| 1 | 2 | 1.05 | 91.42 | 77.9 | 16.7 | 5.4 | 1 : 17.5 |
| 2 | 3 | 1.18 | 91.15 | 80.0 | 17.0 | 3.0 | 1 : 32 |
| 3 | 4 | 0.89 | 92.39 | 83.8 | 15.0 | 1.2 | 1 : 82 |
| 4 | 5 | 0.21 | 97.81 | 99.0 | 0.25 | 0.75 | 1 : 132 |
| 5 | 6 | 0.63 | 95.05 | 98.3 | 1.7 | 0 | |

**Table 3: thin film conductivities and solid contents of PEDOT-S dispersion produced in Examples 7-11**

| Sample # of EDOT-S used to prepare PEDOT-S | Example | solids content [wt.-%] | conductivity [S/cm] |
|---|---|---|---|
| 1 | 7 | 0.87 | 215 |
| 2 | 8 | 1.10 | 253 |
| 3 | 9 | 1.07 | 332 |
| 4 | 10 | 1.16 | 476 |
| 5 | 11 | 1.20 | 718 |

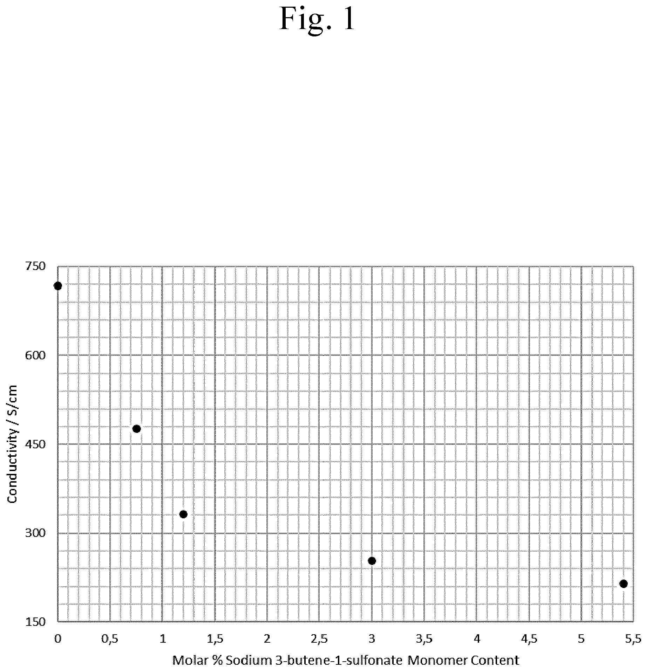

Figure 1 illustrates the relationship between a given thin film's conductivity and the alkene content of the original EDOT-S Na monomer product mixture. The graph illustrates the requirement for low alkene % content to achieve higher conductivities in the final thin film.

## Claims

1. A monomer composition comprising at least one functionalized thiophene monomer having the structure **I** 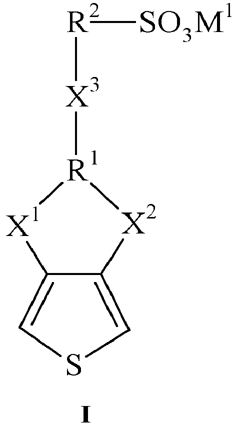 wherein
**X¹** and **X²** represent independently from each other O or S;
**X³** represents CH₂-O with the carbon atom bonded to **R¹** or represents O;
**R¹** represents a trivalent organic group;
**R²** represents a divalent organic group;
**M¹** represents a monovalent cation;
wherein the monomer composition is essentially free of unsaturated organic sulfonic acids having the structure **II** 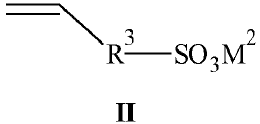 wherein
**R³** represents a divalent organic group;
**M²** represents a monovalent cation;
or wherein the monomer composition comprises unsaturated organic sulfonic acids having the structure **II** in such a maximum amount that the molar ratio of the total amount of unsaturated organic sulfonic acids having the structure **II** to the total amount of functionalized thiophene monomers having structure **I** is 1 : 32 or less.

2. The monomer composition according to claim 1, wherein the monomer composition comprises a functionalized thiophene monomer having the structure **Ia** or structure **Ib** or comprises a mixture of functionalized thiophene monomers having structure **Ia** or **Ib** 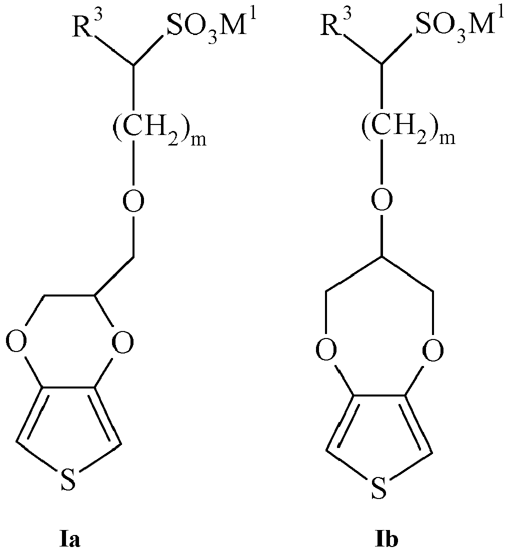 wherein in formulas **Ia** and **Ib**
- **m** is 2 and **R³** is -CH₃;
or
- **m** is 3 and **R³** is H.

3. The monomer composition according to claim 2, wherein in formulas **Ia** and **Ib** m is 3 and **R³** is H.

4. The monomer composition according to anyone of claims 1 to 3, wherein the monomer composition comprises functionalized thiophene monomer having the structure I in a total amount of at least 90 wt.-%, based on the total weight of the monomer composition.

5. The monomer composition according to claim 4, wherein the monomer composition fulfills at least one of the following properties:
i) the monomer composition has a colour value **b*** determined according to ASTM E 308-13 of less than 0.75, the colour value being determined using an aqueous solution that comprises the at least one functionalized thiophene monomer having the structure I in a total amount of 1 wt.-% in a quartz glass cuvette of 0.5 mm in transmission;
ii) the monomer composition has a transmission determined for light with a wavelength of 350 nm of at least 90%.

6. A process for the preparation of a polymer composition comprising a functionalized π-conjugated polythiophene, the process comprising the process steps:
**I)** dissolving or dispersing the monomer composition according to anyone of claims 1 to 5 in a solvent or dispersant to obtain a solution or dispersion of the functionalized thiophene monomer;
**II)** oxidatively polymerizing the functionalized thiophene monomer having the structure **I** in the solution or dispersion provided in process step **I)** to obtain a polymer composition in the form of a solution or dispersion comprising a functionalized π-conjugated polythiophene comprising repeating units having the structure **I'** 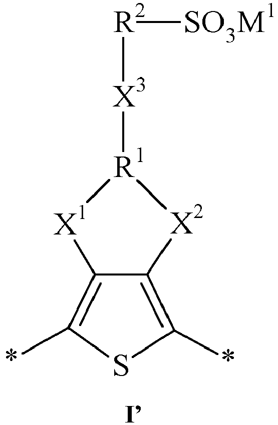 wherein the asterisks (^{∗}) indicate the bond to the adjacent repeating units.

7. A polymer composition comprising a functionalized π-conjugated polythiophene comprising repeating units having the structure **I'** 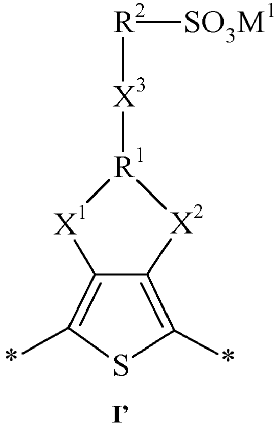 wherein
**X¹** and **X²** represent independently from each other O or S;
**X³** represents CH₂-O with the carbon atom bonded to **R¹** or represents O;
**R¹** represents a trivalent organic group;
**R²** represents a divalent organic group;
**M¹** represents a monovalent cation;
wherein the asterisks (^{∗}) indicate the bond to the adjacent repeating units;
wherein the functionalized π-conjugated polythiophene is essentially free of repeating units having the structure **II'** 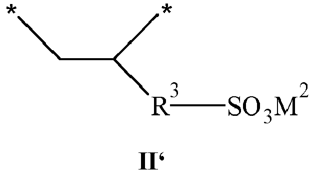 wherein
**R³** represents a divalent organic group;
**M²** represents monovalent cation;
wherein the asterisks (^{∗}) indicate the bond to the adjacent repeating units;
or wherein the functionalized π-conjugated polythiophene comprises repeating units having the structure **II'** in such a maximum amount that the molar ratio of the total amount of repeating units having the structure **II'** to the total amount of repeating units having the structure **I'** is 1 : 32 or less.

8. The polymer composition according to claim 7, wherein the functionalized π-conjugated polythiophene comprises repeating units having the structure **la'** or structure **Ib'** or comprises a mixture of repeating units having structure **la'** or **Ib'** 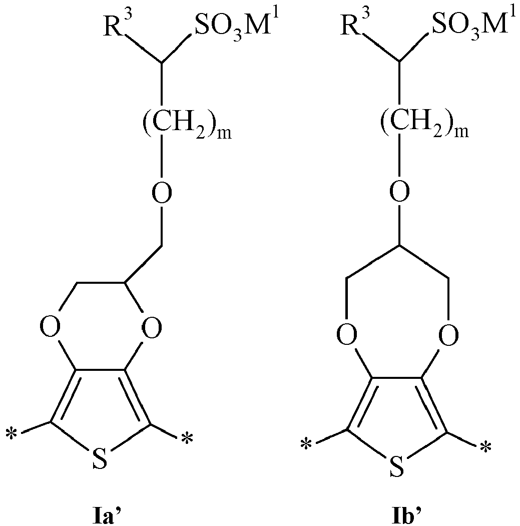 wherein in formulas **la'** and **Ib'**
- **m** is 2 and **R³** is -CH₃;
or
- **m** is 3 and **R³** is H.

9. The polymer composition according to claim 7 or 8, wherein in formulas **la'** and **Ib' m** is 3 and **R³** is H.

10. The polymer composition according to anyone of claims 7 to 9, wherein the polymer composition is a liquid polymer composition further comprising at least one solvent or dispersant, wherein the liquid polymer composition comprises the functionalized π-conjugated polythiophene in an amount in the range from 0.1 to 25% wt.-%, based on the total weight of the liquid polymer composition.

11. The polymer composition according to anyone of claims 7 to 9, wherein the polymer composition is a conductive layer, wherein the conductive layer comprises the functionalized π-conjugated polythiophene in an amount in the range from 50 to 99.9 wt.-%, based on the total weight of the conductive layer.

12. A process for the preparation of a layered body, comprising the process steps:
A) provision of a substrate;
B) application of the polymer composition according to claim 10 onto at least a part of at least one surface of the substrate;
C) optionally at least partial removal of the solvent or dispersant for the formation of a conductive layer that covers at least a part of at least one surface of the substrate.

13. The process according to claim 12, wherein the substrate is an electrode body of an electrode material, wherein a dielectric covers one surface of this electrode material at least partly under formation of an anode body.

14. Use of the monomer composition according to anyone of claims 1 to 5 or of a polymer composition according to anyone of claims 7 to 11 for the preparation of a conductive layer in an electronic device.

15. The use according to claim 14, wherein the electronic device is selected from OLEDs, coated fabrics, photoconductive cells, photoresistors, photoswitches, phototransistors, phototubes, IR detectors, photovoltaic device, solar cells, coating materials for memory storage devices, field effect resistance devices, antistatic films, biosensors, electrochromic devices, solid electrolyte capacitors, energy storage devices, touch panels and electromagnetic shielding.
